# EUROPEAN PATENT APPLICATION

(11) **EP 4 598 316 A1**
(43) Date of publication of application: **06.08.2025**
(21) Application number: 23871978.5
(22) Date of filing: 14.09.2023
(51) Int. Cl.: H10K 50/155, G09F 9/30, H10K 10/40, H10K 30/50, H10K 30/86, H10K 50/10, H10K 50/15, H10K 59/00, H10K 59/10, H10K 85/10, H10K 85/60, H10K 101/30, H10K 101/40

(54) **ORGANIC THIN FILM, ORGANIC ELECTROLUMINESCENT ELEMENT, DISPLAY DEVICE, ILLUMINATION DEVICE, ORGANIC THIN FILM SOLAR CELL, AND ORGANIC THIN FILM TRANSISTOR**

(30) Priority: 29.09.2022 JP 2022156957
(71) Applicant: Nippon Hoso Kyokai, Tokyo 150-8001 (JP); Nippon Soda Co., Ltd., Tokyo 100-7010 (JP)
(72) Inventor: OONO, Taku, Tokyo 157-8510 (JP); FUKAGAWA, Hirohiko, Tokyo 157-8510 (JP); OKADA, Takuya, Tokyo 157-8510 (JP); SASAKI, Tsubasa, Tokyo 157-8510 (JP); SHIMIZU, Takahisa, Tokyo 157-8510 (JP); AMANOKURA, Natsuki, Tokyo 100-7010 (JP); SHIBATA, Hiromoto, Tokyo 100-7010 (JP)
(74) Representative: Scott, Stephen John
(86) International application number: PCT/JP2023/033611
(87) International publication number: WO 2024/070745

(57) **Abstract**

Provided is an organic thin film that uses an organic material with a high electron affinity as a hole injection material and can improve the drive stability of organic devices. An organic thin film that is hole-injectable and contains two or more organic acceptor materials different in electron affinity comprises: a first layer containing an organic acceptor material relatively low in electron affinity; and a second layer stacked on the first layer and containing an organic acceptor material relatively high in electron affinity, wherein the organic acceptor material relatively low in electron affinity is lower in electron affinity than the organic acceptor material relatively high in electron affinity, and the organic thin film is configured to be used with the first layer located on an anode side.

## Description

### TECHNICAL FIELD

The present disclosure relates to an organic thin film, an organic electroluminescent element, a display device, a lighting device, an organic thin film solar cell, and an organic thin film transistor.

### BACKGROUND

In organic devices such as organic electroluminescent (hereafter sometimes abbreviated as "EL") elements, organic thin film solar cells, and organic thin film transistors, charge needs to be transferred between electrodes and organic thin films. Accordingly, hole injection materials and electron injection materials used between electrodes and organic thin films have been actively researched.

To inject electrons into an organic thin film, such an electron injection material that can make the work function of the cathode equal to the electron affinity (EA) of the organic thin film is needed. While conventionally alkali metals have been widely used, the development of organic materials is also progressing (NPL 1).

For hole injection materials, both inorganic and organic materials have been developed (NPL 1). It has been reported that inorganic materials with large work functions, such as molybdenum oxide and nickel oxide, are suitable for hole injection materials. It has also been reported that organic materials with high electron affinities, such as 2,3,6,7,10,11-hexacyano-1,4,5,8,9,12-hexaazatriphenylene (HAT-CN), are suitable for hole injection materials. High electron affinity allows electrons to be extracted from the highest occupied molecular orbital (HOMO) of the organic material, thus generating holes.

HAT-CN is widely used as a hole injection material for organic electroluminescent elements (OLEDs). Other materials reported to have high electron affinities include tetracyanonaphtho-quinodimethane (TNAP), 2,3,5,6-tetrafluoro-7,7,8,8-tetracyanoquinodimethane (F4TCNQ), and hexafluorotetracyanonaphthoquinodimethane (F6TCNNQ). These materials have higher electron affinities than HAT-CN and are considered suitable as hole injection materials.

### CITATION LIST

### Non-patent Literature

NPL 1: Karsten Walzer, Chemical Reviews, 107, 2007, p1233-1271
NPL 2: Satoshi Seo, J. J. Appl. Phys., 53, 2014, p042102
NPL 3: Jeong-Hwan Lee, ACS Applied Materials & Interfaces, 9, 2017, p3277

### SUMMARY

### (Technical Problem)

However, there has been no report of organic devices with excellent stability using materials (TNAP, F4TCNQ, F6TCNNQ, etc.) with high electron affinities other than HAT-CN. If a material with a high electron affinity can be used, it is possible to extract electrons from various organic materials whose ionization potential (IP) is high. This is expected to reduce voltage in organic EL elements, improve power generation efficiency in organic thin film solar cells, and improve mobility in p-type organic thin film transistors, for example.

It could therefore be helpful to provide an organic thin film that uses an organic material with a high electron affinity as a hole injection material and can improve the drive stability of organic devices.

It could also be helpful to provide an organic electroluminescent element, display device, lighting device, organic thin film solar cell, and organic thin film transistor that use such an organic thin film and have excellent drive stability.

### (Solution to Problem)

We have discovered that a hole injection layer having high hole injectability and excellent drive stability can be obtained by using, in a hole injection layer, two or more organic acceptor materials different in electron affinity in such a manner that, out of the two or more organic acceptor materials, an organic acceptor material relatively low in electron affinity is located on the anode side and an organic acceptor material relatively high in electron affinity is stacked on the organic acceptor material relatively low in electron affinity.

We thus provide the following organic thin film, organic electroluminescent element, display device, lighting device, organic thin film solar cell, and organic thin film transistor according to the present disclosure.
[1] An organic thin film that is hole-injectable and contains two or more organic acceptor materials different in electron affinity, the organic thin film comprising:
   a first layer containing an organic acceptor material relatively low in electron affinity; and
   a second layer stacked on the first layer and containing an organic acceptor material relatively high in electron affinity,
   wherein the organic acceptor material relatively low in electron affinity is lower in electron affinity than the organic acceptor material relatively high in electron affinity, and
   the organic thin film is configured to be used with the first layer located on an anode side.
[2] The organic thin film according to [1], wherein the organic acceptor material relatively low in electron affinity has an electron affinity of less than 4.5 eV, and
   the organic acceptor material relatively high in electron affinity has an electron affinity of 4.5 eV or more.
[3] The organic thin film according to [1] or [2], wherein the second layer is a film obtained by mixing the organic acceptor material relatively high in electron affinity with another organic material.
[4] The organic thin film according to any one of [1] to [3], wherein the organic acceptor materials are each a cyano-containing compound or a fluorine-containing compound.
[5] The organic thin film according to any one of [1] to [4], wherein the organic acceptor materials are each a compound containing a 2-methylenepropanedinitrile group.
[6] The organic thin film according to any one of [1] to [3], wherein the organic acceptor material relatively low in electron affinity is any of a fluorine-containing compound, an aromatic hydrocarbon, a phosphonic acid, and a material forming a self-assembled monolayer.
[7] The organic thin film according to any one of [1] to [3], wherein the organic acceptor material relatively low in electron affinity has an electron affinity of 0.35 eV or more and less than 4.5 eV.
[8] An organic electroluminescent element comprising a cathode, a light-emitting layer, and an anode in the stated order, and comprising the organic thin film according to any one of [1] to [7] between the anode and the light-emitting layer,
   wherein the first layer of the organic thin film is located on an anode side.
[9] The organic electroluminescent element according to [8], wherein an average thickness of the organic thin film is 2 nm to 100 nm.
[10] A display device comprising the organic electroluminescent element according to [8] or [9].
[11] A lighting device comprising the organic electroluminescent element according to [8] or [9].
[12] An organic thin film solar cell comprising the organic thin film according to any one of [1] to [7].
[13] An organic thin film transistor comprising the organic thin film according to any one of [1] to [7].

### (Advantageous Effect)

It is thus possible to provide an organic thin film that can improve the drive stability of organic devices.

It is also possible to provide an organic electroluminescent element, display device, lighting device, organic thin film solar cell, and organic thin film transistor that use such an organic thin film and have excellent drive stability.

### BRIEF DESCRIPTION OF THE DRAWINGS

In the accompanying drawings:
FIG. 1 is a schematic diagram illustrating an example of the structure of an organic EL element according to the present disclosure;
FIG. 2 is a schematic diagram illustrating two structural examples of a hole injection layer in the organic EL element according to the present disclosure;
FIG. 3 is an explanatory diagram illustrating energy levels in organic EL elements of examples and comparative examples;
FIG. 4 illustrates the inverse photoelectron spectra of organic acceptor materials used in examples and comparative examples;
FIG 5 is an explanatory diagram illustrating the relationship between a structural example of a hole injection layer and its electron affinity;
FIG. 6 is a graph illustrating the relationship between the applied voltage and the current density in each of the organic EL elements of Examples 1 to 4;
FIG. 7 is a graph illustrating the relationship between the applied voltage and the current density in each of the organic EL elements of Comparative Examples 1 to 7;
FIG. 8 is a graph illustrating the relationship between the applied voltage and the current density in each of the organic EL elements of Examples 5 to 8 and Comparative Examples 8 to 9; and
FIG. 9 is a graph illustrating the correlation between the measured and calculated electron affinity values for a plurality of organic materials.

### DETAILED DESCRIPTION

An organic thin film, an organic electroluminescent element, a display device, a lighting device, an organic thin film solar cell, and an organic thin film transistor according to the present disclosure will be described in detail below by way of embodiments.

### <Organic thin film>

An organic thin film according to this embodiment is an organic thin film that is hole-injectable and contains two or more organic acceptor materials different in electron affinity. The organic thin film according to this embodiment comprises: a first layer containing an organic acceptor material relatively low in electron affinity; and a second layer stacked on the first layer and containing an organic acceptor material relatively high in electron affinity. The organic acceptor material relatively low in electron affinity is lower in electron affinity than the organic acceptor material relatively high in electron affinity, and the organic thin film is configured to be used with the first layer located on an anode side.

There are two methods of actually measuring electron affinity: low-energy inverse photoemission spectroscopy (LEIPS), and a method that measures ionization energy and optical gap and then performing subtraction. However, the electron affinity depends on the measurement method. For example, the value measured using optical gap is approximately 0.5 eV greater than the value measured using LEIPS. Hence, in this specification, the electron affinity (EA) of an organic acceptor material is a calculated value, specifically, a value calculated using molecular orbital calculation [Density functional theory, B3LYP, basis set: 6-31G(d)].

Organic acceptor materials can attract electrons from adjacent molecules or atoms. An organic acceptor material with a higher electron affinity (EA) can attract electrons more easily. When a film made of an organic acceptor material with a high electron affinity is formed on an anode, the amount of electron transfer from the anode to the organic acceptor material increases, and the film made of the organic acceptor material is strongly negatively charged. This strongly negatively charged state is not a stable state. Thus, if a film of an organic acceptor material with a high electron affinity is formed on the anode of an organic device, the drive stability of the organic device decreases.

In the organic thin film according to this embodiment, the first layer located on the anode side contains the organic acceptor material relatively low in electron affinity, and the second layer stacked on the first layer contains the organic acceptor material relatively high in electron affinity. As a result of the first layer that contains the organic acceptor material relatively low in electron affinity being provided on the anode side, the amount of electron transfer from the anode side is reduced, and the first layer is prevented from being negatively charged and made to approach neutrality. This can improve the stability of the first layer and improve the drive stability of the organic device that uses the organic thin film.

Moreover, as a result of the second layer that contains the organic acceptor material relatively high in electron affinity being provided on the first layer (i.e., on the cathode side of the first layer), the second layer extracts electrons from the cathode side (for example, a hole transport layer in an organic EL element). This can reduce voltage in organic EL elements, improve power generation efficiency in organic thin film solar cells, and improve mobility in p-type organic thin film transistors.

The organic thin film according to this embodiment is an organic thin film that is hole-injectable and contains two or more organic acceptor materials different in electron affinity. The number of types of organic acceptor materials contained may be two, or three or more. The organic thin film according to this embodiment has hole injectability, i.e., a property of injecting holes transferred from the anode side into the layer adjacent on the cathode side.

The organic thin film according to this embodiment comprises: a first layer containing an organic acceptor material relatively low in electron affinity; and a second layer stacked on the first layer and containing an organic acceptor material relatively high in electron affinity, and may further comprise another layer besides the first layer and the second layer. The organic acceptor material relatively low in electron affinity used in the first layer is lower in electron affinity than the organic acceptor material relatively high in electron affinity used in the second layer.

As mentioned above, as a result of the first layer that contains the organic acceptor material relatively low in electron affinity being provided on the anode side, the amount of electron transfer from the anode side is reduced, and the first layer is prevented from being negatively charged. Therefore, the organic thin film according to this embodiment is used with the first layer located on the anode side.

The electron affinity of the organic acceptor material relatively low in electron affinity is preferably less than 4.5 eV. If the electron affinity of the organic acceptor material relatively low in electron affinity used in the first layer is less than 4.5 eV, the amount of electron transfer from the anode side is further reduced, and the first layer is further prevented from being negatively charged and made to approach neutrality. This can further improve the stability of the first layer and further improve the drive stability of the organic device that uses the organic thin film. Although no lower limit is placed on the electron affinity of the organic acceptor material relatively low in electron affinity, the electron affinity of the organic acceptor material relatively low in electron affinity is 0.35 eV or more in one embodiment, and 1.0 eV or more in another embodiment. The electron affinity of the organic acceptor material relatively low in electron affinity is preferably 0.35 eV or more and less than 4.5 eV.

The electron affinity of the organic acceptor material relatively high in electron affinity is preferably 4.5 eV or more and more preferably 4.8 eV or more, and is preferably 7.0 eV or less. If the electron affinity of the organic acceptor material relatively high in electron affinity used in the second layer is 4.5 eV or more, the second layer can more easily extract electrons from the cathode side (for example, a hole transport layer in an organic EL element). This can further reduce voltage in organic EL elements, further improve power generation efficiency in organic thin film solar cells, and further improve mobility in p-type organic thin film transistors.

The second layer may be a film made of the organic acceptor material relatively high in electron affinity, but it is also preferable that the second layer is a film obtained by mixing the organic acceptor material relatively high in electron affinity with another organic material. The other organic material is, for example, a donor material. As the donor material, the material used in the hole transport layer of the organic EL element described later may be used.

In the case where the second layer is a film obtained by mixing the organic acceptor material relatively high in electron affinity with another organic material, the ratio of the organic acceptor material to the other organic material is preferably 5.0 : 95.0 to 50.0 : 50.0 in mass ratio (organic acceptor material : other organic material).

As the organic acceptor materials, various hole-injectable organic materials may be used. In one embodiment, cyano-containing compounds and fluorine-containing compounds are preferable, and compounds containing a 2-methylenepropanedinitrile group are more preferable. If the organic acceptor materials are cyano-containing compounds or fluorine-containing compounds, the hole injectability of the organic thin film is improved. If the organic acceptor materials are compounds containing a 2-methylenepropanedinitrile group, the hole injectability of the organic thin film is further improved. Here, the 2-methylenepropanedinitrile group is a group having a structure in which two cyano groups are bonded to one of the carbons constituting a carbon-carbon double bond [=C(CN)₂], and is also called a dicyanomethylene group.

Examples of the cyano-containing compounds include 2,3,6,7,10,11-hexacyano-1,4,5,8,9,12-hexaazatriphenylene (HAT-CN), tetracyanonaphtho-quinodimethane (TNAP), 2,3,5,6-tetrafluoro-7,7,8,8-tetracyanoquinodimethane (F4TCNQ), hexafluorotetracyanonaphthoquinodimethane (F6TCNNQ), and hexacyano-trimethylene-cyclopropane (CN6-CP).

Examples of the fluorine-containing compounds include 2,3,5,6-tetrafluoro-7,7,8,8-tetracyanoquinodimethane (F4TCNQ), hexafluorotetracyanonaphthoquinodimethane (F6TCNNQ), and 1,2,3,4,5,6,7,8-octafluoro-9,10-bis[4-(trifluoromethyl)phenyl]anthracene.

Examples of the compounds containing a 2-methylenepropanedinitrile group include tetracyanonaphtho-quinodimethane (TNAP), 2,3,5,6-tetrafluoro-7,7,8,8-tetracyanoquinodimethane (F4TCNQ), hexafluorotetracyanonaphthoquinodimethane (F6TCNNQ), and hexacyano-trimethylene-cyclopropane (CN6-CP).

The organic acceptor material relatively high in electron affinity used in the second layer is preferably a compound containing a 2-methylenepropanedinitrile group. Since compounds containing a 2-methylenepropanedinitrile group have a particularly high electron affinity (EA), the second layer can more easily extract electrons from the cathode side (for example, a hole transport layer in an organic EL element). This can further reduce voltage in organic EL elements, further improve power generation efficiency in organic thin film solar cells, and further improve mobility in p-type organic thin film transistors.

In one embodiment, the organic acceptor material relatively low in electron affinity used in the first layer is preferably any of a fluorine-containing compound, an aromatic hydrocarbon, a phosphonic acid, and a material forming a self-assembled monolayer. These materials further reduce the amount of electron transfer from the anode side, and further prevent the first layer from being negatively charged and make the first layer approach neutrality. This can further improve the stability of the first layer and further improve the drive stability of the organic device that uses the organic thin film. An example of the fluorine-containing compound is 1,2,3,4,5,6,7,8-octafluoro-9,10-bis[4-(trifluoromethyl)phenyl]anthracene (BCF3Ph-F8-Ant). An example of the aromatic hydrocarbon is 2-(9,9'-spirobifluorene-2-yl)-9,9'-spirobifluorene (BSBF). An example of the phosphonic acid is 4-fluorobenzylphosphonic acid (FP-ly-POA). An example of the material forming a self-assembled monolayer is 4-fluorobenzylphosphonic acid (FP-ly-POA).

### <Organic electroluminescent element>

An organic electroluminescent element according to this embodiment comprises a cathode, a light-emitting layer, and an anode in this order, and comprises the above-described organic thin film between the anode and the light-emitting layer. In the organic EL element in this embodiment, the first layer of the organic thin film is located on the anode side.

In the organic EL element according to this embodiment, since the first layer of the organic thin film is located on the anode side, the amount of electron transfer from the anode side is reduced and the first layer is prevented from being negatively charged and made to approach neutrality. This can improve the stability of the first layer and improve the drive stability of the organic EL element.

Moreover, in the organic EL element according to this embodiment, since the second layer of the organic thin film is located on the first layer (i.e., the cathode side of the first layer), the second layer extracts electrons from the cathode side (for example, a hole transport layer, a light-emitting layer, etc.), with it being possible to reduce voltage.

In the organic EL element according to this embodiment, the average thickness of the organic thin film is preferably 2 nm to 100 nm and more preferably 5 nm to 100 nm. If the average thickness of the organic thin film is 2 nm to 100 nm, the drive stability of the organic EL element can be further improved and the drive voltage can be further reduced.

The average thickness of the organic thin film can be measured by a stylus step gauge or spectroscopic ellipsometry.

The organic EL element according to this embodiment will be described in detail below using an example.

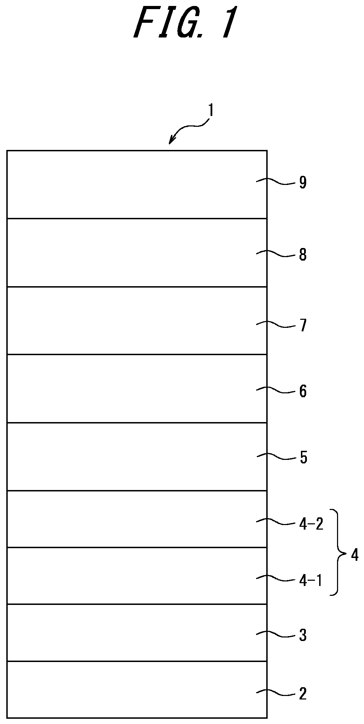

FIG. 1 is a schematic sectional view for explaining an example of the organic EL element according to this embodiment. An organic EL element 1 illustrated in FIG. 1 includes a light-emitting layer 6 between an anode 3 and a cathode 9, and also includes the organic thin film according to this embodiment as a hole injection layer 4 between the anode 3 and the light-emitting layer 6.

More specifically, the organic EL element 1 illustrated in FIG. 1 has a stack (laminate) structure in which an anode 3, a hole injection layer (organic thin film) 4, a hole transport layer 5, a light-emitting layer 6, an electron transport layer 7, an electron injection layer 8, and a cathode 9 are formed in this order on a substrate 2, and the hole injection layer (organic thin film) 4 has a first layer 4-1 on the anode 3 side and a second layer 4-2 on the hole transport layer 5 side.

In the organic EL element 1 illustrated in FIG. 1, holes are injected from the anode 3 and electrons are injected from the cathode 9, and their charges reach the light-emitting layer 6 respectively through the transport layers 5 and 7 and recombine to generate light. The organic EL element 1 illustrated in FIG. 1 may be a top emission type that extracts light on the side opposite the substrate 2, or a bottom emission type that extracts light on the substrate 2 side.

### (Substrate)

Examples of the material of the substrate 2 include resin materials and glass materials. The material of the substrate 2 may be one type or a combination of two or more types.

Examples of the resin materials used for the substrate 2 include polyethylene terephthalate, polyethylene naphthalate, cycloolefin polymer, polyamide, polyether sulfone, polymethyl methacrylate, polycarbonate, and polyarylate. The use of a resin material as the material of the substrate 2 is preferable because the organic EL element 1 can have excellent flexibility.

Examples of the glass materials used for the substrate 2 include quartz glass and soda glass.

In the case where the organic EL element 1 is a bottom emission type, a transparent substrate is used as the material of the substrate 2.

In the case where the organic EL element 1 is a top emission type, not only a transparent substrate but also an opaque substrate may be used as the material of the substrate 2. Examples of the opaque substrate include a substrate made of a ceramic material such as alumina, a substrate with an oxide film (insulating film) formed on the surface of a metal plate such as stainless steel, and a substrate made of a resin material.

The average thickness of the substrate 2 can depend on, for example, the material of the substrate 2, and is preferably 0.1 mm to 30 mm and more preferably 0.1 mm to 10 mm. The average thickness of the substrate 2 can be measured using a digital multimeter or a vernier caliper.

### (Electrode)

In the organic EL element 1 according to this embodiment, known conductive materials may be used as appropriate as the anode 3 and the cathode 9, but it is preferable that at least one of the anode 3 and the cathode 9 is transparent in order to extract light. Examples of known transparent conductive materials include tin-doped indium oxide (ITO), antimony-doped indium oxide (ATO), indium-doped zinc oxide (IZO), aluminum-doped zinc oxide (AZO), and fluorine-doped indium oxide (FTO).

Examples of opaque conductive materials include calcium, magnesium, aluminum, barium, tin, indium, copper, silver, ytterbium, and alloys thereof.

Among these, ITO, IZO, and FTO are preferable as the anode 3.

On the other hand, Al and AgMg alloys are preferable as the cathode 9.

The average thickness of the anode 3 is not limited, but is preferably 10 nm to 500 nm and more preferably 70 nm to 200 nm. The average thickness of the anode 3 can be measured by a stylus step gauge or spectroscopic ellipsometry.

The average thickness of the cathode 9 is not limited, but is preferably 10 nm to 1000 nm and more preferably 30 nm to 150 nm. In the case of using an opaque material, for example, limiting the average thickness to about 10 nm to 30 nm allows the cathode 9 to be used for a top emission and transparent type. The average thickness of the cathode 9 can be measured during film formation using a quartz crystal film thickness meter.

### (Hole injection layer)

The hole injection layer 4 can have the same structure as the above-described organic thin film. In detail, the hole injection layer 4 comprises: a first layer 4-1 containing an organic acceptor material relatively low in electron affinity; and a second layer 4-2 stacked on the first layer 4-1 and containing an organic acceptor material relatively high in electron affinity, and the first layer 4-1 is located on the anode 3 side. This structure makes it possible to form the hole injection layer 4 with improved hole injectability and stability.

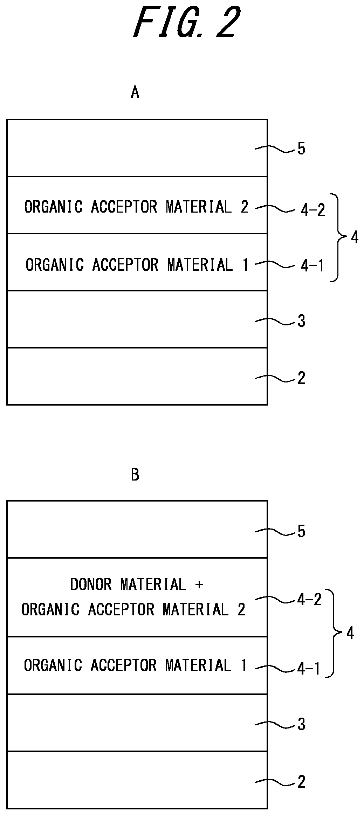

In the organic EL element 1 according to this embodiment, it is preferable to form the hole injection layer 4 by stacking two organic acceptor materials together. Here, the hole injection layer 4 may have various structures. For example, as illustrated in FIG. 2A, a first layer 4-1 containing an organic acceptor material relatively low in electron affinity (organic acceptor material 1) and a second layer 4-2 containing an organic acceptor material relatively high in electron affinity (organic acceptor material 2) may be stacked together to form the hole injection layer 4. Alternatively, as illustrated in FIG. 2B, a layer (second layer 4-2) of a mixture of an organic acceptor material relatively high in electron affinity (organic acceptor material 2) and a donor material may be stacked on a single film (first layer 4-1) of an organic acceptor material relatively low in electron affinity (organic acceptor material 1) to form the hole injection layer 4.

As the donor material mixed with the organic acceptor material, the material of the hole transport layer 5 described later may be used. In the case where the second layer 4-2 contains an organic acceptor material and a donor material, the ratio of the organic acceptor material to the donor material is preferably 5.0 : 95.0 to 50.0 : 50.0 in mass ratio (organic acceptor material : donor material).

The form of the hole injection layer in the organic EL element according to the present disclosure is not limited to such, and other structures may be used.

The average thickness of the hole injection layer 4 is not limited, but is preferably 1 nm to 1000 nm, more preferably 2 nm to 100 nm, further preferably 5 nm to 100 nm, and particularly preferably 5 nm to 50 nm. The average film thickness of each of the first layer 4-1 and the second layer 4-2 is preferably in the range of 1 nm to 50 nm.

The average thickness of the hole injection layer 4 (first layer 4-1 and second layer 4-2) can be measured, for example, by a stylus step gauge or spectroscopic ellipsometry.

### (Hole transport layer)

As the material of the hole transport layer 5, any compound (donor material) that can be typically used as a material for a hole transport layer may be used, and various p-type high molecular materials and various p-type low molecular materials may be used alone or in combination.

Examples of the p-type high molecular materials (organic polymers) include polyarylamine, fluorene-arylamine copolymer, fluorene-bithiophene copolymer, poly(N-vinylcarbazole), polyvinylpyrene, polyvinylanthracene, polythiophene, polyalkylthiophene, polyhexylthiophene, poly(p-phenylenevinylene), polythienylenevinylene, pyrene formaldehyde resin, ethylcarbazole formaldehyde resin, and derivatives thereof. These high molecular materials may be used in mixtures with other compounds. As an example, a mixture containing polythiophene is poly(3,4-ethylenedioxythiophene/styrenesulfonic acid) (PEDOT/PSS).

Examples of the p-type low molecular materials include arylcycloalkane-based compounds such as 1,1-bis(4-di-para-triaminophenyl)cyclohexane and 1,1'-bis(4-di-para-tolylaminophenyl)-4-phenyl-cyclohexane; arylamine-based compounds such as 4,4',4"-trimethyltriphenylamine, N,N,N',N'-tetraphenyl-1,1'-biphenyl-4,4'-diamine, N,N'-diphenyl-N,N'-bis(3-methylphenyl)-1,1'-biphenyl-4,4'-diamine (TPD1), N,N'-diphenyl-N,N'-bis(4-methoxyphenyl)-1,1'-biphenyl-4,4'-diamine (TPD2), N,N,N',N'-tetrakis(4-methoxyphenyl)-1,1'-biphenyl-4,4'-diamine (TPD3), N,N'-di(1-naphthyl)-N,N'-diphenyl-1,1'-biphenyl-4,4'-diamine (α-NPD), 4,4'-bis[N-phenyl-N-[4'-diphenylamino-1,1'-biphenyl-4-yl]amino]-1,1'-biphenyl (TPTE), and tris(4-carbazolyl-9-ylphenyl)amine (TcTa); phenylenediamine-based compounds such as N,N,N',N'-tetraphenyl-para-phenylenediamine, N,N,N',N'-tetra(para-tolyl)-para-phenylenediamine, and N,N,N',N'-tetra(meta-tolyl)-meta-phenylenediamine (PDA); carbazole-based compounds such as carbazole, N-isopropylcarbazole, and N-phenylcarbazole; stilbene-based compounds such as stilbene and 4-di-para-tolylaminostilbene; oxazole-based compounds such as OxZ; triphenylmethane-based compounds such as triphenylmethane and 4,4',4"-tris(N-3-methylphenyl-N-phenylamino)triphenylamine (m-MTDATA); pyrazoline-based compounds such as 1-phenyl-3-(para-dimethylaminophenyl)pyrazoline; benzine (cyclohexadiene)-based compounds; triazole-based compounds such as triazole; imidazole-based compounds such as imidazole; oxadiazole-based compounds such as 1,3,4-oxadiazole and 2,5-di(4-dimethylaminophenyl)-1,3,4-oxadiazole; anthracene-based compounds such as anthracene and 9-(4-diethylaminostyryl)anthracene; fluorenone-based compounds such as fluorenone, 2,4,7-trinitro-9-fluorenone, and 2,7-bis(2-hydroxy-3-(2-chlorophenylcarbamoyl)-1-naphthylazo)fluorenone; aniline-based compounds such as polyaniline; silane-based compounds; pyrrole-based compounds such as 1,4-dithioketo-3,6-diphenyl-pyrrolo-(3,4-c)pyrrolopyrrole; fluorene-based compounds such as fluorene; porphyrin-based compounds such as porphyrin and metallotetraphenylporphyrin; quinacridone-based compounds such as quinacridone; metallic or non-metallic phthalocyanine-based compounds such as phthalocyanine, copper phthalocyanine, tetra(t-butyl)copper phthalocyanine, and iron phthalocyanine; metallic or non-metallic naphthalocyanine-based compounds such as copper naphthalocyanine, vanadyl naphthalocyanine, and monochlorogallium naphthalocyanine; and benzidine-based compounds such as N,N'-di(naphthalene-1-yl)-N,N'-diphenyl-benzidine and N,N,N',N'-tetraphenylbenzidine. These may be used alone or in a combination of two or more. Among these, arylamine-based compounds such as TcTa, α-NPD, and TPTE are particularly preferable.

The average thickness of the hole transport layer 5 is not limited, but is preferably 5 nm to 150 nm and more preferably 10 nm to 100 nm.

The average thickness of the hole transport layer 5 can be measured, for example, by a stylus step gauge or spectroscopic ellipsometry.

### (Light-emitting layer)

In the organic EL element 1 according to this embodiment, the material forming the light-emitting layer 6 may be a low molecular compound, a high molecular compound, or a mixture thereof. In the present disclosure, a low molecular material means a material that is not a high molecular material (polymer), and does not necessarily mean an organic compound with a low molecular weight.

Moreover, a donor material, an electron transport material, etc., may be mixed in the light-emitting layer 6 besides a material commonly called a light-emitting material. Examples of the donor material include the materials used in the hole transport layer 5 described above. Examples of the electron transport material include the materials used in the electron transport layer 7 described later.

Examples of the high molecular material forming the light-emitting layer 6 include polyacetylene-based compounds such as trans-polyacetylene, cis-polyacetylene, poly(di-phenylacetylene) (PDPA), and poly(alkyl, phenylacetylene) (PAPA); polyparaphenylenevinylene-based compounds such as poly(para-phenylenevinylene) (PPV), poly(2,5-dialkoxy-para-phenylenevinylene) (RO-PPV), cyano-substituted-poly(para-phenylenevinylene) (CN-PPV), poly(2-dimethyloctylsilyl-para-phenylenevinylene) (DMOS-PPV), and poly(2-methoxy, 5-(2'-ethylhexoxy)-para-phenylenevinylene) (MEH-PPV); polythiophene-based compounds such as poly(3-alkylthiophene) (PAT) and poly(oxypropylene)triol (POPT); polyfluorene-based compounds such as poly(9,9-dialkylfluorene) (PDAF), poly(dioctylfluorene-alto-benzothiadiazole) (F8BT), α,ω-bis[N,N'-di(methylphenyl)aminophenyl]-poly[9,9-bis(2-ethylhexyl)fluorene-2,7-diyl] (PF2/6am4), and poly(9,9-dioctyl-2,7-divinylenefluorenyl-ortho-co(anthracene-9,10-diyl); polyparaphenylene-based compounds such as poly(para-phenylene) (PPP) and poly(1,5-dialkoxy-para-phenylene) (RO-PPP); polycarbazole-based compounds such as poly(N-vinylcarbazole) (PVK); polysilane-based compounds such as poly(methylphenylsilane) (PMPS), poly(naphthylphenylsilane) (PNPS), and poly(biphenylylphenylsilane) (PBPS); and boron compound-based high molecular materials described in JP 2011-184430 A and JP 2012-151148 A.

Examples of the low molecular material forming the light-emitting layer 6 include various metal complexes such as three-coordinate iridium complexes with 2,2'-bipyridine-4,4'-dicarboxylic acid as the ligand, fac-tris(2-phenylpyridine)iridium (Ir(ppy)₃), fac-tris(3-methyl-2-phenylpyridinato-N, C2'-)iridium(III) (Ir(mppy)₃), 8-hydroxyquinolinealuminum (Alq₃), tris(4-methyl-8-quinolinolato)aluminum(III) (Almq₃), 8-hydroxyquinoline zinc (Znq₂), (1,10-phenanthroline)-tris-(4,4,4-trifluoro-1-(2-thienyl)-butane-1,3-dionate)europium(III) (Eu(TTA)₃(phen)), and 2,3,7,8,12,13,17,18-octaethyl-21H,23H-porphine platinum(II); benzene-based compounds such as distyrylbenzene (DSB) and diaminodistyrylbenzene (DADSB); naphthalene-based compounds such as naphthalene and nile red; phenanthrene-based compounds such as phenanthrene; chrysene-based compounds such as chrysene and 6-nitrochrysene; perylene-based compounds such as perylene and N,N'-bis(2,5-di-t-butylphenyl)-3,4,9,10-perylene-di-carboximide (BPPC); coronene-based compounds such as coronene; anthracene-based compounds such as anthracene and bisstyrylanthracene; pyrene-based compounds such as pyrene; pyran-based compounds such as 4-(dicyanomethylene)-2-methyl-6-(para-dimethylaminostyryl)-4H-pyran (DCM); acridine-based compounds such as acridine; stilbene-based compounds such as stilbene; carbazole-based compounds such as 4,4'-bis[9-dicarbazolyl]-2,2'-biphenyl (CBP) and 4,4'-bis(9-ethyl-3-carbazovinylene)-1,1'-biphenyl (BCzVBi); thiophene-based compounds such as 2,5-dibenzoxazolethiophene; benzoxazole-based compounds such as benzoxazole; benzimidazole-based compounds such as benzimidazole; benzothiazole-based compounds such as 2,2'-(para-phenylenedivinylene)-bisbenzothiazole; butadiene-based compounds such as bistyryl(1,4-diphenyl-1,3-butadiene) and tetraphenylbutadiene; naphthalimide -based compounds such as naphthalimide; coumarin-based compounds such as coumarin; perinone-based compounds such as perinone; oxadiazole-based compounds such as oxadiazole; aldazine-based compounds; cyclopentadiene-based compounds such as 1,2,3,4,5-pentaphenyl-1,3-cyclopentadiene (PPCP); quinacridone-based compounds such as quinacridone and quinacridone red; pyridine-based compounds such as pyrrolopyridine and thiadiazolopyridine; triazine-based compounds such as 2,4-diphenyl-6-bis(12-phenylindolo[2,3-a]carbazole-11-yl)-1,3,5-triazine (DIC-TRZ); spiro compounds such as 2,2',7,7'-tetraphenyl-9,9'-spirobifluorene; metallic or non-metallic phthalocyanine-based compounds such as phthalocyanine (H₂Pc) and copper phthalocyanine; and boron compound materials described in JP 2009-155325 A and JP 5660371 B2. These may be used alone or in a combination of two or more. Quantum dots and perovskite materials may also be used as the light-emitting layer.

The average thickness of the light-emitting layer 6 is not limited, but is preferably 10 nm to 150 nm and more preferably 20 nm to 100 nm.

The average thickness of the light-emitting layer 6 may be measured using a stylus step gauge, or may be measured using a quartz crystal film thickness meter during the formation of the light-emitting layer 6.

### (Electron transport layer)

As the material of the electron transport layer 7, a wide variety of known materials capable of transporting electrons (electron transport materials) can be used. Specific examples include phosphine oxide derivatives such as phenyl-dipyrenylphosphine oxide (POPy₂); pyridine derivatives such as tris-1,3,5-(3'-(pyridine-3"-yl)phenyl)benzene (TmPhPyB); quinoline derivatives such as 2-(3-(9-carbazolyl)phenyl)quinoline (mCQ); pyrimidine derivatives such as 2-phenyl-4,6-bis(3,5-dipyridylphenyl)pyrimidine (BPyPPM); pyrazine derivatives; phenanthroline derivatives such as bathophenanthroline (BPhen); triazine derivatives such as 2,4-bis(4-biphenyl)-6-(4'-(2-pyridinyl)-4-biphenyl)-[1,3,5]triazine (MPT), 2,4,6-tris(m-pyridine-3-yl-phenyl)triazine (TmPPyTz), and 2,4-diphenyl-6-bis(12-phenylindolo[2,3-a]carbazole-11-yl)-1,3,5-triazine (DIC-TRZ); triazole derivatives such as 3-phenyl-4-(1'-naphthyl)-5-phenyl-1,2,4-triazole (TAZ); oxazole derivatives; oxadiazole derivatives such as 2-(4-biphenyl)-5-(4-tert-butylphenyl-1,3,4-oxadiazole) (PBD); imidazole derivatives such as 2,2',2"-(1,3,5-benzenetriyl)-tris(1-phenyl-1-H-benzimidazole) (TPBI); tetracarboxylic acid anhydrides of aromatic rings such as naphthalene and perylene; various metal complexes such as bis[2-(2-hydroxyphenyl)benzothiazolato]zinc (Zn(BTZ)₂) and tris(8-hydroxyquinolinato)aluminum (Alq₃); organic silane derivatives such as silole derivatives, e.g., 2,5-bis(6'-(2',2"-bipyridyl))-1,1-dimethyl-3,4-diphenylsilole (PyPySPyPy); and boron-containing compounds described in JP 2013-239691 A, WO 2014/133141 A1, JP 2016-172728 A, JP 2016-199507 A, and JP 2016-199508 A. These may be used alone or in a combination of two or more.

The average thickness of the electron transport layer 7 is not limited, but is preferably 10 nm to 150 nm and more preferably 20 nm to 100 nm.

The average thickness of the electron transport layer 7 can be measured by a stylus step gauge or spectroscopic ellipsometry.

### (Electron injection layer)

The material used for the electron injection layer 8 is selected from the viewpoints of the work function of the cathode 9, the LUMO level of the electron transport layer 7, etc. In the case where the electron transport layer 7 is not provided, the material is selected in consideration of the LUMO level of the material used for the light-emitting layer 6. The material of the electron injection layer 8 may be an organic compound or an inorganic compound. In the case where the electron injection layer 8 is made of an inorganic compound, for example, an alkali metal, an alkaline earth metal, lithium fluoride, sodium fluoride, potassium fluoride, cesium fluoride, or cesium carbonate may be used. In the case where the electron injection layer 8 is made of an organic compound, for example, 8-quinolinolatolithium (Liq), a hexahydropyrimidopyrimidine compound having the structure represented by the following general formula (1), or a compound having the structure represented by the following general formula (2) may be used.

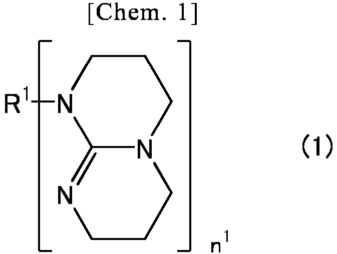

In general formula (1), R¹ represents an aromatic hydrocarbon group, an aromatic heterocyclic group, an arylalkylene group, a divalent to tetravalent chain or cyclic hydrocarbon group, which may have a substituent, a group formed by combining two or more of these groups, or a group formed by combining one or more of these groups with a nitrogen atom. n¹ is an integer of 1 to 4.

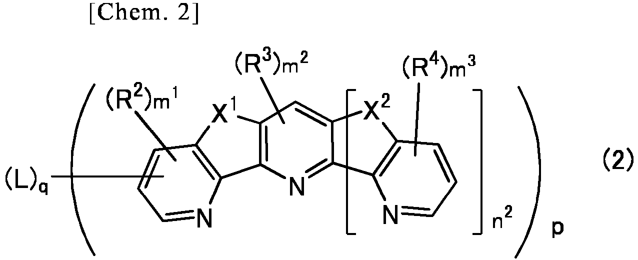

In general formula (2), X¹ and X² are the same or different and each represent a nitrogen atom, an oxygen atom, a sulfur atom, or a divalent linking group, which may have a substituent. L represents a direct bond or a p-valent linking group, n² represents a number of 0 or 1, p represents a number of 1 to 4, q represents a number of 0 or 1, and q is 0 when p is 1. R² to R⁴ are the same or different and each represent a monovalent substituent, and m¹ to m³ are the same or different and each represent a number of 0 to 3. R² to R⁴ may be bonded to X¹ and X² to form a ring structure. In the case where there are a plurality of R², the plurality of R² may be bonded to form a ring structure. In the case where there are a plurality of R³, the plurality of R³ may be bonded to form a ring structure. In the case where there are a plurality of R⁴, the plurality of R⁴ may be bonded to form a ring structure.

R¹ in the above general formula (1) represents an aromatic hydrocarbon group, an aromatic heterocyclic group, an arylalkylene group, a divalent to tetravalent chain or cyclic hydrocarbon group, which may have a substituent, a group formed by combining two or more of these groups, or a group formed by combining one or more of these groups with a nitrogen atom.

The aromatic hydrocarbon group and the aromatic heterocyclic group preferably have a carbon number of 3 to 30, more preferably have a carbon number of 4 to 24, and further preferably have a carbon number of 5 to 20.

Examples of the aromatic hydrocarbon group include compounds consisting of only one aromatic ring, such as benzene; compounds in which a plurality of aromatic rings are directly bonded to each other at one carbon atom, such as biphenyl and diphenylbenzene; and groups formed by removing one to four hydrogen atoms from any of the aromatic rings of condensed ring aromatic hydrocarbon compounds, such as naphthalene, anthracene, phenanthrene, and pyrene.

Examples of the aromatic heterocyclic group include groups formed by removing one to four hydrogen atoms from any of the aromatic heterocyclic rings of compounds consisting of only one aromatic heterocyclic ring, such as thiophene, furan, pyrrole, oxazole, oxadiazole, thiazole, thiadiazole, imidazole, pyridine, pyrimidine, pyrazine, and triazine; compounds (such as bipyridine) in which a plurality of such compounds consisting of only one aromatic heterocyclic ring are directly bonded to each other at one carbon atom; and condensed ring heteroaromatic hydrocarbon compounds, such as quinoline, quinoxaline, benzothiophene, benzothiazole, benzimidazole, benzoxazole, indole, carbazole, dibenzofuran, dibenzothiophene, acridine, and phenanthroline.

Examples of the arylalkylene group include groups formed by combining the foregoing aromatic hydrocarbon groups with alkylene groups having a carbon number of 1 to 3.

The divalent to tetravalent chain or cyclic hydrocarbon group preferably has a carbon number of 1 to 12, more preferably has a carbon number of 1 to 6, and further preferably has a carbon number of 1 to 4. The chain hydrocarbon group may be linear or branched.

R¹ may also be a group formed by combining two or more of the foregoing aromatic hydrocarbon groups, aromatic heterocyclic groups, arylalkylene groups, and divalent to tetravalent chain hydrocarbon groups.

R¹ may also be a group formed by combining one or more of the foregoing aromatic hydrocarbon groups, aromatic heterocyclic groups, arylalkylene groups, and divalent to tetravalent chain hydrocarbon groups with a nitrogen atom. Examples of such a group include groups formed by removing one to four hydrogen atoms from triphenylamine or trialkylamine such as trimethylamine.

The foregoing aromatic hydrocarbon group, aromatic heterocyclic group, or arylalkylene group may have one or more monovalent substituents.

Examples of the monovalent substituents include a fluorine atom; haloalkyl groups such as fluoromethyl group, difluoromethyl group, and trifluoromethyl group; linear or branched alkyl groups having a carbon number of 1 to 20 such as methyl group, ethyl group, propyl group, isopropyl group, butyl group, isobutyl group, and tert-butyl group; cyclic alkyl groups having a carbon number of 5 to 7 such as cyclopentyl group, cyclohexyl group, and cycloheptyl group; linear or branched alkoxy groups having a carbon number of 1 to 20 such as methoxy group, ethoxy group, propoxy group, isopropoxy group, butoxy group, isobutoxy group, tert-butoxy group, pentyloxy group, hexyloxy group, heptyloxy group, and octyloxy group; nitro group; cyano group; alkylamino groups having an alkyl group having a carbon number of 1 to 10 such as methylamino group, ethylamino group, dimethylamino group, and diethylamino group; cyclic amino groups such as pyrrolidino group, piperidino group, and morpholino group; diarylamino groups such as diphenylamino group and carbazolyl group; acyl groups such as acetyl group, propionyl group, and butyryl group; alkenyl groups having a carbon number of 2 to 30 such as styryl group; aryl groups having a carbon number of 5 to 20 which may be substituted by a halogen atom such as a fluorine atom or an alkyl group, alkoxy group, or amino group having a carbon number of 1 to 20 (specific examples of the aryl groups are the same as those of the aromatic hydrocarbon groups described above); heterocyclic groups containing one or more of a nitrogen atom, a sulfur atom, and an oxygen atom having a carbon number of 4 to 40, which may be substituted by a halogen atom such as a fluorine atom or an alkyl group, alkoxy group, or amino group having a carbon number of 1 to 20 (the heterocyclic groups may be those consisting of only one ring, may be those in which a plurality of compounds consisting of only one aromatic heterocyclic ring are directly bonded to each other at one carbon atom, or may be condensed heterocyclic groups, and specific examples of the heterocyclic groups include aromatic heterocyclic groups such as thiophene ring, furan ring, pyrrole ring, benzothiophene ring, benzofuran ring, indole ring, dibenzothiophene ring, dibenzofuran ring, carbazole ring, thiazole ring, benzothiazole ring, oxazole ring, benzoxazole ring, imidazole ring, benzimidazole ring, pyridine ring, pyrimidine ring, pyrazine ring, pyridazine ring, triazine ring, quinoline ring, isoquinoline ring, quinoxaline ring, benzothiadiazole ring, and phenanthridine ring); ester group; and thioether group. These groups may be substituted by a halogen atom, a hetero element, an alkyl group, an aromatic ring, etc.

In the above general formula (1), n¹ is an integer of 1 to 4, and is preferably 2 or 3.

The compound represented by the above general formula (1) can be synthesized by Ullmann coupling reaction, Buchwald-Hartwig amination reaction, nucleophilic substitution reaction, or the like, using a halogen compound containing iodine, bromine, chlorine, or fluorine and hexahydropyrimidopyrimidine as raw materials.

X¹ and X² in the above general formula (2) are the same or different and each represent a nitrogen atom, an oxygen atom, a sulfur atom, or a divalent linking group, which may have a substituent.

Examples of the divalent linking group include divalent hydrocarbon groups and groups in which part of the carbon atoms of hydrocarbon groups is substituted by a heteroatom such as a nitrogen atom, an oxygen atom, or a sulfur atom.

The hydrocarbon groups preferably have a carbon number of 1 to 6 and more preferably have a carbon number of 1, 2, or 6.

The hydrocarbon groups may be linear, branched, cyclic, or a combination thereof.

The divalent hydrocarbon groups may each be an alkylene group which is a saturated hydrocarbon group, or an unsaturated hydrocarbon group such as an alkenylene group or an alkynylene group.

L in the above general formula (2) represents a direct bond or a p-valent linking group. L is a direct bond only when p is 2.

Examples of the p-valent linking group include a nitrogen atom, an oxygen atom, a sulfur atom, a carbon atom, hydrocarbon groups, and groups formed by removing p hydrogen atoms from groups in which part of the carbon atoms of hydrocarbon groups is substituted by a heteroatom such as a nitrogen atom, an oxygen atom, or a sulfur atom.

In the case where the p-valent linking group has one or more carbon atoms, its carbon number is preferably 1 to 30 and more preferably 1 to 20.

The hydrocarbon groups may be linear, branched, cyclic, or a combination thereof.

The hydrocarbon groups may be saturated hydrocarbon groups, unsaturated hydrocarbon groups, or aromatic hydrocarbon groups.

Examples of the aromatic hydrocarbon groups include groups formed by removing hydrogen atoms from aromatic compounds such as a benzene ring, naphthalene ring, anthracene ring, tetracene ring, pentacene ring, triphenylene ring, pyrene ring, fluorene ring, and indene ring.

R² to R⁴ in the above general formula (2) are the same or different and each represent a monovalent substituent, and m¹ to m³ in the above general formula (2) are the same or different and each represent a number of 0 to 3.

Examples of the monovalent substituent include a fluorine atom; haloalkyl groups such as fluoromethyl group, difluoromethyl group, and trifluoromethyl group; linear or branched alkyl groups having a carbon number of 1 to 20 such as methyl group, ethyl group, propyl group, isopropyl group, butyl group, isobutyl group, and tert-butyl group; cyclic alkyl groups having a carbon number of 5 to 7 such as cyclopentyl group, cyclohexyl group, and cycloheptyl group; linear or branched alkoxy groups having a carbon number of 1 to 20 such as methoxy group, ethoxy group, propoxy group, isopropoxy group, butoxy group, isobutoxy group, tert-butoxy group, pentyloxy group, hexyloxy group, heptyloxy group, and octyloxy group; nitro group; cyano group; alkylamino groups having an alkyl group having a carbon number of 1 to 10 such as methylamino group, ethylamino group, dimethylamino group, and diethylamino group; cyclic amino groups such as pyrrolidino group, piperidino group, and morpholino group; diarylamino groups such as diphenylamino group and carbazolyl group; acyl groups such as acetyl group, propionyl group, and butyryl group; alkenyl groups having a carbon number of 2 to 30 such as styryl group; aryl groups having a carbon number of 5 to 20 which may be substituted by a halogen atom such as a fluorine atom or an alkyl group, alkoxy group, or amino group having a carbon number of 1 to 20 (specific examples of the aryl groups are the same as those of the aromatic hydrocarbon groups described above); heterocyclic groups containing one or more of a nitrogen atom, a sulfur atom, and an oxygen atom having a carbon number of 4 to 40, which may be substituted by a halogen atom such as a fluorine atom or an alkyl group, alkoxy group, or amino group having a carbon number of 1 to 20 (the heterocyclic groups may be those consisting of only one ring, may be those in which a plurality of compounds consisting of only one aromatic heterocyclic ring are directly bonded to each other at one carbon atom, or may be condensed heterocyclic groups, and specific examples of the heterocyclic groups include aromatic heterocyclic groups such as thiophene ring, furan ring, pyrrole ring, benzothiophene ring, benzofuran ring, indole ring, dibenzothiophene ring, dibenzofuran ring, carbazole ring, thiazole ring, benzothiazole ring, oxazole ring, benzoxazole ring, imidazole ring, benzimidazole ring, pyridine ring, pyrimidine ring, pyrazine ring, pyridazine ring, triazine ring, quinoline ring, isoquinoline ring, quinoxaline ring, benzothiadiazole ring, and phenanthridine ring); ester group; and thioether group. These groups may be substituted by a halogen atom, a hetero element, an alkyl group, an aromatic ring, etc.

In the above general formula (2), p represents a number of 1 to 4, and is preferably a number of 1 to 3.

In the above general formula (2), n² represents a number of 0 or 1, and is preferably 0.

The average thickness of the electron injection layer 8 may be 1 nm to several µm, but is preferably 1 nm to 1000 nm and more preferably 2 nm to 100 nm from the viewpoint of enabling the organic EL element to be driven at low voltage. The average thickness of the electron injection layer 8 can be measured by a stylus step gauge or spectroscopic ellipsometry.

### (Formation method)

The organic EL element 1 illustrated in FIG. 1 can be produced by forming the anode 3, the hole injection layer 4, the hole transport layer 5, the light-emitting layer 6, the electron transport layer 7, the electron injection layer 8, and the cathode 9 in this order on the substrate 2. The method of forming each of the anode 3, the hole injection layer 4, the hole transport layer 5, the light-emitting layer 6, the electron transport layer 7, the electron injection layer 8, and the cathode 9 is not limited, and various conventionally known formation methods may be used as appropriate depending on the properties of the material used for each layer. Examples of methods that can be used to form each layer include chemical vapor deposition (CVD) methods such as plasma CVD, thermal CVD, and laser CVD, dry plating methods such as vacuum deposition, sputtering, and ion plating, and thermal spraying method, which are vapor phase film formation methods; and wet plating methods such as electrolytic plating, immersion plating, and electroless plating, and printing techniques such as sol-gel method, MOD method, spray pyrolysis method, doctor blade method using fine particle dispersion, spin coating method, inkjet method, and screen printing method, which are liquid phase film formation methods. It is preferable to select any of these methods depending on the properties of the material of each layer, and the formation method may differ depending on the layer.

The organic EL element 1 according to this embodiment can change the emission color by appropriately selecting the material of the light-emitting layer 6, and a desired emission color can be obtained by additionally using a color filter or the like. Therefore, the organic EL element according to the present disclosure is suitable for use in display devices and lighting devices.

### (Other examples)

The organic EL element according to the present disclosure is not limited to the organic EL element described in the foregoing embodiment.

Specifically, although the foregoing embodiment describes an example in which the organic EL element 1 has a normal structure in which the anode 3 is located between the substrate 2 and the light-emitting layer 6, the organic EL element according to the present disclosure may have an inverted structure in which the cathode is located between the substrate and the light-emitting layer.

In the organic EL element according to the present disclosure, the hole transport layer, the electron transport layer, and the electron injection layer are optionally formed and may be omitted.

Each of the anode, hole injection layer, hole transport layer, light-emitting layer, electron transport layer, electron injection layer, and cathode may consist of one layer or of two or more layers.

The organic EL element according to the present disclosure may comprise one or more other layers between adjacent layers of the anode, hole injection layer, hole transport layer, light-emitting layer, electron transport layer, electron injection layer, and cathode. Specifically, the organic EL element may optionally comprise an electron blocking layer, etc., for reasons such as further improving the properties of the organic EL element.

### <Display device>

A display device according to the present disclosure comprises the above-described organic electroluminescent element. As a result of comprising the above-described organic EL element having low drive voltage and excellent drive stability, the display device according to the present disclosure has low drive voltage and excellent drive stability. The display device according to the present disclosure may comprise other components typically used in display devices in addition to the above-described organic electroluminescent element.

### <Lighting device>

A lighting device according to the present disclosure comprises the above-described organic electroluminescent element. As a result of comprising the above-described organic EL element having low drive voltage and excellent drive stability, the lighting device according to the present disclosure has low drive voltage and excellent drive stability. The lighting device according to the present disclosure may comprise other components typically used in lighting devices in addition to the above-described organic electroluminescent element.

### <Organic thin film solar cell, organic thin film transistor>

The present disclosure is not limited to the foregoing embodiment, and the organic thin film according to the present disclosure may be used in devices such as organic thin film solar cells and organic thin film transistors.

An organic thin film solar cell according to the present disclosure comprises the organic thin film. For example, the use of the organic thin film as the hole injection layer in the organic thin film solar cell facilitates injection of holes, so that the speed of hole transport increases and high power generation efficiency is achieved. A desirable organic thin film solar cell or photoelectric conversion element is thus obtained.

An organic thin film transistor according to the present disclosure comprises the organic thin film. For example, providing the above-described organic thin film on an electrode can improve mobility.

### EXAMPLES

The presently disclosed technology will be described in more detail below by way of examples, although the present disclosure is not limited to the following examples.

To demonstrate the effectiveness of the presently disclosed technology, organic EL elements were selected as organic devices. By driving a plurality of organic EL elements that depend on the hole injection layer with a constant current and measuring the changes in luminance, it is possible to evaluate the stability of the hole injection layer. Although the examples and comparative examples described here relate to organic EL elements, the organic thin film according to the present disclosure can also be used in organic thin film solar cells and organic thin film transistors that use organic materials.

The layer structure of the organic EL element 1 produced is as illustrated in FIG. 1, that is, includes the anode 3, the hole injection layer 4, the hole transport layer 5, the light-emitting layer 6, the electron transport layer 7, the electron injection layer 8, and the cathode 9. The properties of each organic EL element dependent on the hole injection layer 4 were evaluated.

### <Materials used in hole transport layer 5, light-emitting layer 6, electron transport layer 7, and electron injection layer 8>

In this embodiment, an exciplex consisting of a donor material and another material was used as the host of the light-emitting layer 6. Moreover, the donor material was used in the hole transport layer 5, and the other material was used in the electron transport layer 7.

Specifically, Ir(mppy)₃ was used as a light-emitting material, DIC-TRZ was used as the other material used in the formation of the exciplex (electron transport layer 7), and Py-hpp₂ was used as the electron injection layer 8.

Here, the movement of electrons from the donor material (the material used in the hole transport layer 5) to the hole injection layer 4 is closely related to the hole injection property. Hence, the selection of the donor material is important in discussing the hole injection layer 4. It has been previously reported that efficient hole injection is possible between N,N'-diphenyl-N,N'-bis(1-naphthalenyl)-1,1'-biphenyl-4,4'-diamine (α-NPD), a common donor material with an ionization potential (IP) of about 5.4 eV, and HAT-CN, a widely used hole injection layer material (Yong-Ki Kim, Applied. Physics. Letters. 94, 2009, p063305).

In this embodiment, in order to discuss the device application of materials with high electron affinities (EA), tris(4-carbazolyl-9-ylphenyl)amine (TcTa) with an ionization potential (IP) of about 5.7 eV was selected as a donor material into which holes cannot be efficiently injected from HAT-CN.

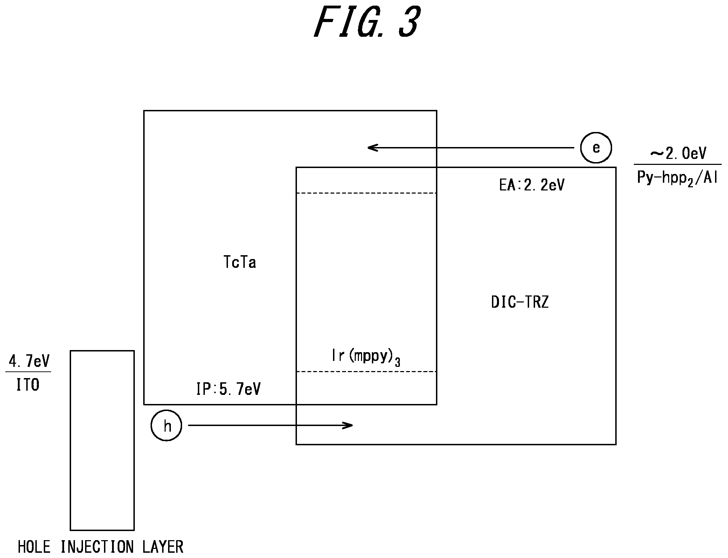

As illustrated in FIG. 3, there is no energy barrier in the organic EL element 1 according to this embodiment, so that the influence of the hole injection layer 4 on the properties of the organic EL element 1 can be investigated accurately.

In this embodiment, organic EL elements in both the form in which organic acceptor materials are stacked to form the hole injection layer 4 as illustrated in FIG. 2A and the form in which a layer of a mixture of an organic acceptor material and a donor material is stacked on a single film of an organic acceptor material to form the hole injection layer 4 as illustrated in FIG. 2B were produced.

### <Organic acceptor materials used in hole injection layer 4>

In this embodiment, three types of cyano-containing compounds, HAT-CN, TNAP, and F6TCNNQ, were mainly used as organic acceptor materials in the hole injection layer 4.

Moreover, F16CuPc was used as an organic acceptor material other than cyano compounds.

The structures of the materials used in the hole injection layer 4 are as follows.

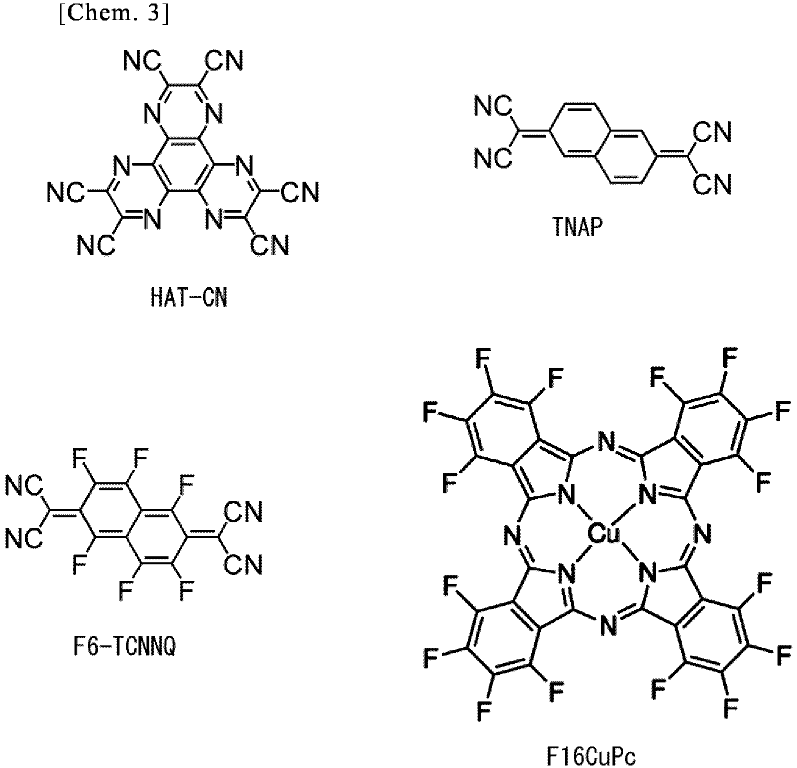

It has been reported in recent years that the electron affinity (EA) of an organic acceptor material is highly dependent on the charged state of the organic acceptor material and the electron affinity decreases when the organic acceptor material is negatively charged (David Kiefer, Nature Materials, 18, 2019, p149-155). Hence, the correlation of the electron affinities (EA) of three materials, HAT-CN, TNAP, and F6TCNNQ, was investigated using molecular orbital calculation [Density functional theory, B3LYP, basis set: 6-31G(d)]. The results are shown in Table 1.

**[Table 1]**

| | EA (Calculated value, eV)* | EA (Measured value, eV) |
|---|---|---|
| HAT-CN | 4.4 | 4.3 |
| TNAP | 4.7 | 4.7 |
| F6TCNNQ | 5.0 | 5.0 |

| | | |
|---|---|---|
| * Molecular orbital calculation [Density functional theory, B3LYP, basis set: 6-31G(d)] | | |

As shown in Table 1, the electron affinity (EA) differed depending on the material, and HAT-CN had the lowest electron affinity (EA) and F6TCNNQ had the highest electron affinity (EA) of the three materials.

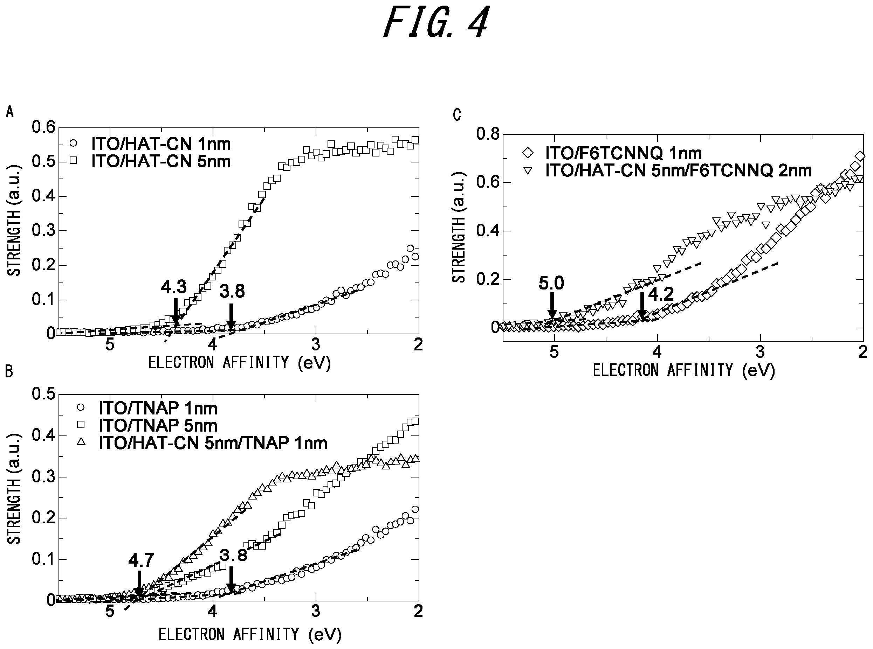

FIG. 4 illustrates the results of measuring the electron affinities of the respective materials using low-energy inverse photoemission spectroscopy (LEIPS).

As illustrated in FIG. 4A, in the case where a 1 nm film of HAT-CN was formed on ITO, the electron affinity (EA) was approximately 3.8 eV. In the case where a 5 nm film of HAT-CN was formed on ITO, the electron affinity (EA) increased to 4.3 eV.

As illustrated in FIG. 4B, in the case where a 1 nm film of TNAP was formed on ITO, the electron affinity (EA) was 3.8 eV. In the case where a 5 nm film of TNAP was formed on ITO, the electron affinity (EA) was 4.7 eV. In the case where a 5 nm film of HAT-CN was formed on ITO and a 1 nm film of TNAP was formed on the HAT-CN film, the electron affinity (EA) was 4.7 eV.

As illustrated in FIG. 4C, in the case where a 1 nm film of F6TCNNQ was formed on ITO, the electron affinity (EA) was 4.2 eV. In the case where a 5 nm film of HAT-CN was formed on ITO and a 1 nm film of F6TCNNQ was formed on the HAT-CN film, the electron affinity (EA) was 5.0 eV.

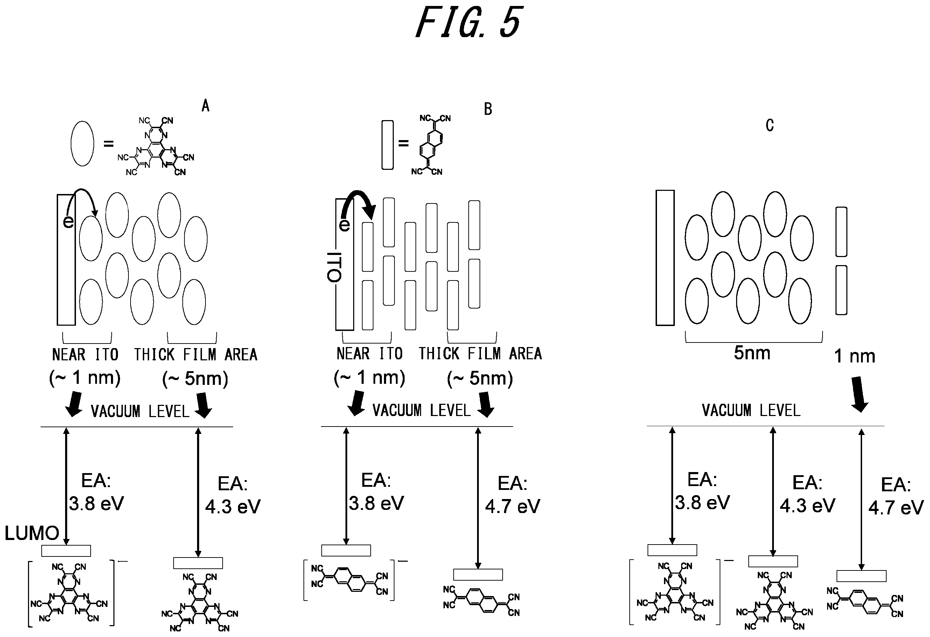

FIG. 5 schematically illustrates these results. Thus, when an extremely thin film of an organic acceptor material is formed on a substrate, the organic acceptor material is negatively charged due to charge transfer from the substrate and the electron affinity (EA) is low. On the other hand, the electron affinity (EA) of the organic acceptor material away from the substrate is high. It was also found that there is a strong correlation between the measured values of the electron affinity (EA) in the neutral state by LEIPS and the estimated values of the electron affinity (EA) by molecular orbital calculation. Accordingly, while four types of materials were used to produce organic EL elements in this example, materials with high electron affinities (EA) calculated by molecular orbital calculation, such as CN6-CP (EA calculated value: 5.4 eV, Jing Li, Material Horizons, 6, 2019, p107-114) and TECTFCNBN (EA calculated value: 5.3 eV, Zhenhua Ci, Organic Electronics 95, 2021, p106197) represented by the following structural formulas are also considered suitable for the present disclosure.

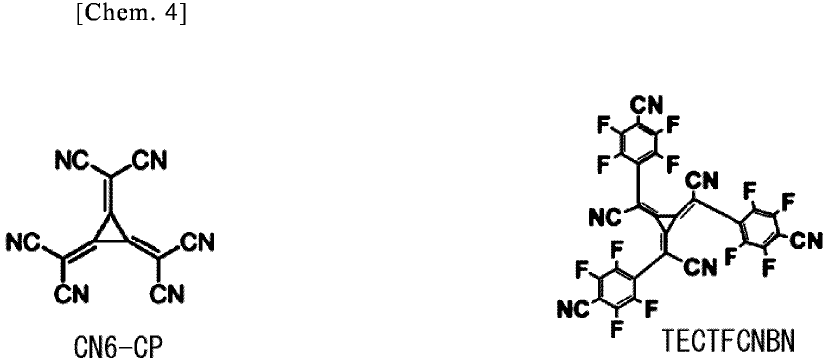

### <Examples 1 to 8 and Comparative Examples 1 to 9>

A commercially available transparent glass substrate having an electrode (anode 3) made of ITO with a thickness of 100 nm was provided as the substrate 2. The hole injection layer 4 (first layer 4-1 and second layer 4-2), hole transport layer 5, light-emitting layer 6, electron transport layer 7, electron injection layer 8, and cathode 9 were stacked in this order on the anode 3 of the substrate 2.

The structures of the hole injection layer 4 (first layer 4-1 and second layer 4-2) and hole transport layer 5 are as shown in Table 2.

As common layers, Ir(mppy)₃, TcTa, and DIC-TRZ were co-deposited on the hole transport layer 5 as the light-emitting layer 6 [Ir(mppy)₃ : TcTa : DIC-TRZ (mass ratio) = 0.05 : 0.475 : 0.475, thickness 30 nm], a film of DIC-TRZ was formed as the electron transport layer 7 (thickness 40 nm), Py-hpp₂ and DIC-TRZ were co-deposited as the electron injection layer 8 [Py-hpp₂ : DIC-TRZ (mass ratio) = 0.4 : 0.6, thickness 5 nm], and Al (thickness 100 nm) was stacked as the cathode 9. Sealing was then performed using glass and UV-curable resin.

The structures of the materials used in the hole transport layer 5, the light-emitting layer 6, the electron transport layer 7, and the electron injection layer 8 are as follows.

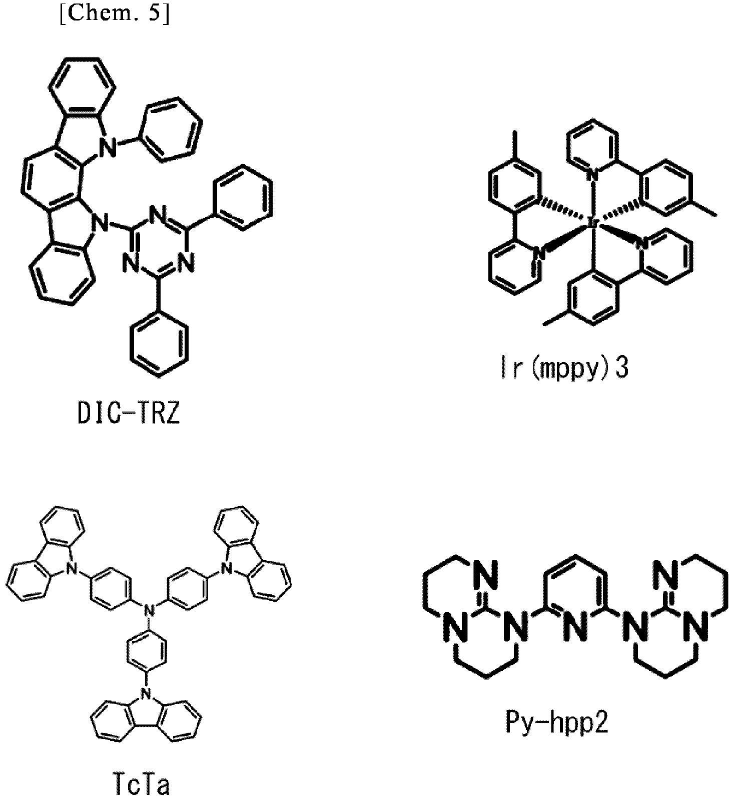

Here, Py-hpp2 was synthesized according to the method described in T. Sasaki, M. Hasegawa, K. Inagaki, H. Ito, K. Suzuki, T. Oono, K. Morii, T. Shimizu, and H. Fukagawa, Nature Communications, 12, pp.2706.1, DOI: 10.1038/s41467-021-23067-2.

A voltage was applied to each of the organic EL elements of Examples 1 to 8 and Comparative Examples 1 to 9 obtained in this manner using 2400 Source Meter produced by Keithley Instruments, and the luminance was measured using LS-100 produced by Konica Minolta, Inc. The relationship between the applied voltage and the luminance and the relationship between the applied voltage and the current density were then examined.

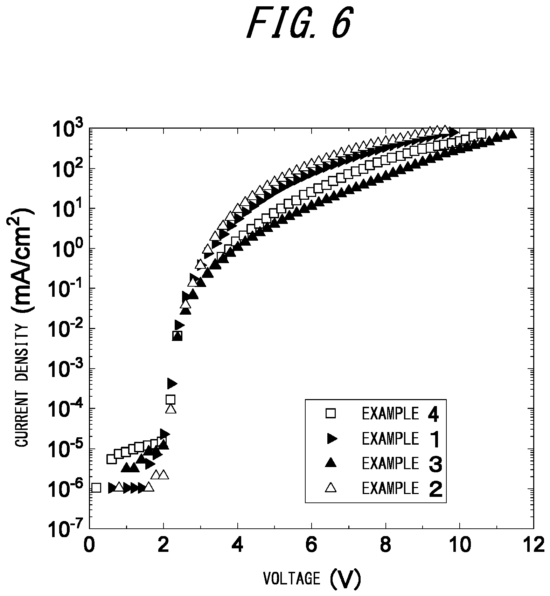

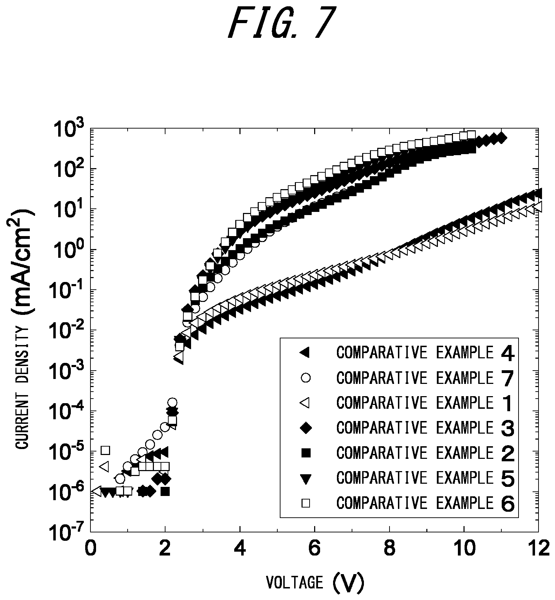

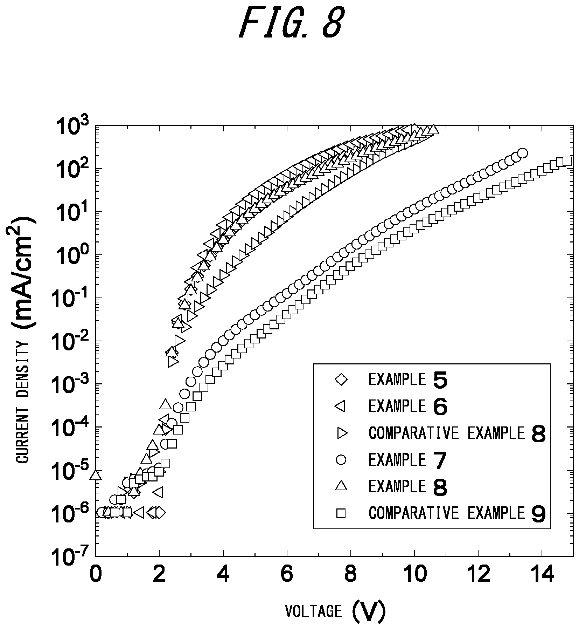

FIGS. 6 to 8 illustrate the current density-voltage characteristics of a plurality of organic EL elements dependent on the hole injection layer.

Table 2 shows the structures of the hole injection layer 4 and hole transport layer 5 of Examples 1 to 8 and Comparative Examples 1 to 9, and the properties of the organic EL elements 1 produced using them. The results in the drawings and table indicate that how the current flows is highly dependent on the hole injection layer 4.

**[Table 2]**

| | Anode/Hole injection layer | Hole transport layer | Current density at 4V (mA/cm²) | Current density at 5V (mA/cm²) | Current density at 6V (mA/cm²) | Voltage at 10000 nits (V) | Current density at 10000 nits (mA/cm²) | Half luminance life from 10000 nits (hour) |
|---|---|---|---|---|---|---|---|---|
| Example 1 | ITO/HAT-CN 5nm/F6TCNNQ 1nm | TcTa 30 nm | 5.55 | 26.6 | 76.4 | 4.8 | 20 | 550 |
| Example 2 | ITO/HAT-CN 5nm/F6TCNNQ 2nm | TcTa 30 nm | 9.38 | 45.15 | 124.4 | 4.4 | 19.6 | - |
| Example 3 | ITO/HAT-CN 5nm/TNAP 1nm | TcTa 30 nm | 1.05 | 4 | 11.33 | 6.8 | 23.1 | 120 |
| Example 4 | ITO/F16CuPc 1nm/F6TCNNQ 1nm | TcTa 30 nm | 1.42 | 7.6 | 26.1 | 5.8 | 20.9 | 131 |
| Example 5 | ITO/HAT-CN 5 nm/ TcTa doped with 10wt% F6TCNNQ 20 nm | TcTa 10 nm | 2.25 | 11.18 | 36.12 | 5.6 | 23.4 | 290 |
| Example 6 | ITO/HAT-CN 5 nm/F6TCNNQ 1 nm/ TcTa doped with 10wt% F6TCNNQ 20 nm | TcTa 10 nm | 4.93 | 26.03 | 77.66 | 5 | 26.03 | 330 |
| Example 7 | ITO/HAT-CN 5 nm/ TcTa doped with 10wt% TNAP 20 nm | TcTa 10 nm | 0.01 | 0.04 | 0.13 | 11.4 | 38.84 | - |
| Example 8 | ITO/HAT-CN 5 nm/F6TCNNQ 1 nm/ TcTa doped with 10wt% TNAP 20 nm | TcTa 10 nm | 2.21 | 11.64 | 35.12 | 5.6 | 23.66 | 300 |
| Comparative Example 1 | ITO/HAT-CN 1nm | TcTa 30 nm | 0.06 | 0.13 | 0.24 | 15.2 | 49.2 | 54 |
| Comparative Example 2 | ITO/TNAP 1nm | TcTa 30 nm | 1.05 | 4 | 10.97 | 6.8 | 22.5 | 12 |
| Comparative Example 3 | ITO/F6TCNNQ 1nm | TcTa 30 nm | 2.83 | 10.7 | 25.42 | 5.6 | 18 | 90 |
| Comparative Example 4 | ITO/HAT-CN 5nm | TcTa 30 nm | 0.03 | 0.07 | 0.14 | 12.4 | 31.5 | 61 |
| Comparative Example 5 | ITO/TNAP 5nm | TcTa 30 nm | 2.62 | 11.64 | 33.37 | 5.8 | 27.4 | 22 |
| Comparative Example 6 | ITO/F6TCNNQ 2 nm | TcTa 30 nm | 4.08 | 18.93 | 52.41 | 5 | 18.9 | 100 |
| Comparative Example 7 | ITO/F6TCNNQ 1nm/HAT-CN 5nm | TcTa 30 nm | 0.71 | 3.58 | 11.3 | 6.6 | 19.8 | 110 |
| Comparative Example 8 | ITO/TcTa doped with 10wt% F6TCNNQ 20 nm | TcTa 10 nm | 0.33 | 1.83 | 7.74 | 6.8 | 20.92 | 205 |
| Comparative Example 9 | ITO/TcTa doped with 10wt% TNAP 20 nm | TcTa 10 nm | 0.002 | 0.01 | 0.04 | 13.8 | 74.75 | 56 |

| | | | | | | | | |
|---|---|---|---|---|---|---|---|---|
| * The film thickness of ITO is all 100nm. | | | | | | | | |

As can be understood from the results of Comparative Examples 1, 2, and 3, with the same thickness of the hole injection layer, the hole injectability of the organic EL element is highly dependent on the electron affinity (EA) of the material. When the same voltage was applied, the current density increased in the order of HAT-CN, TNAP, and F6TCNNQ. This demonstrates that it is easier to extract electrons from the donor material TcTa when the electron affinity (EA) of the organic acceptor material used in the hole injection layer is higher.

Next, look at the drive stability of Comparative Examples 1, 2, and 3. It has been reported that the drive stability of organic EL elements using Ir(mppy)₃ as a light-emitting material is about 300 hours in terms of half luminance life when continuously driven from an initial luminance of 10000 cd/m² (Tsubasa Sasaki, Nature Communications, 12, 2021, p2706). However, the half luminance life of each of the organic EL elements of Comparative Examples 1, 2, and 3 was 100 hours or less, exhibiting poor drive stability.

Next, look at the results of Example 1 in which 5 nm of HAT-CN and 1 nm of F6TCNNQ were stacked to form the hole injection layer. Inserting 5 nm of HAT-CN made it possible to obtain higher current density than Comparative Example 3 in which the same 1 nm film of F6TCNNQ was used, demonstrating improvement in hole injectability. In addition, the half luminance life as an index of drive stability was 550 hours. Thus, the insertion of 5 nm of HAT-CN dramatically increased the life by 5 times or more.

For Example 3 in which 5 nm of HAT-CN and 1 nm of TNAP were stacked to form the hole injection layer, the same results as Example 1 were obtained. In detail, inserting 5 nm of HAT-CN made it possible to obtain higher current density than Comparative Example 2 in which the same 1 nm film of TNAP was used, demonstrating improvement in hole injectability. In addition, regarding the half luminance life as an index of drive stability, the insertion of 5 nm of HAT-CN dramatically increased the life by about 10 times.

It was thus revealed that a hole injection layer with excellent hole injectability and drive stability can be formed by forming a film of an organic acceptor material high in electron affinity (EA) on HAT-CN which is an organic acceptor material relatively low in electron affinity (EA).

The reason why such a hole injection layer using a plurality of organic acceptor materials has excellent hole injectability and drive stability is presumed as follows.

Organic acceptor materials can attract electrons from adjacent molecules or atoms. An organic acceptor material with a higher electron affinity (EA) can attract electrons more easily. Of the three materials used here, F6TCCNNQ and TNAP more easily attract electrons than HAT-CN. When a film of each of these organic acceptor materials is formed on a substrate, the amount of electron transfer from the substrate to the organic acceptor material is greater in the case of F6TCNNQ and TNAP than in the case of HAT-CN, suggesting that F6TCCNNQ and TNAP are more strongly negatively charged than HAT-CN. This strongly negatively charged state is not a stable state. This is likely why the organic EL elements of Comparative Examples 2 and 3 had poor drive stability even with relatively successful hole injection.

In Examples 1 and 3 in which HAT-CN was inserted, on the other hand, F6TCNNQ and TNAP were able to be neutral without being negatively charged because of less electron transfer from the substrate, and therefore able to be in contact with the donor material in a state of having high electron affinity (EA), with it being possible to drive the organic EL element at low voltage. Given that a state of being negatively charged on ITO is considered to be unstable, as a result of F6TCNNQ and TNAP being neutral on HAT-CN, an organic EL element with excellent drive stability was obtained.

Moreover, the significantly worse properties and life of the organic EL element of Comparative Example 7 than that of Example 1 suggest the importance of the order of stacking, that is, it is important to stack an organic acceptor material low in electron affinity on the anode and stack an organic acceptor material high in electron affinity on the organic acceptor material low in electron affinity.

The organic EL element of Example 4 in which F16CuPc was inserted between ITO and F6TCNNQ was higher in drive voltage but better in drive stability than that of Comparative Example 3. These results seem to support the presumption regarding the drive stability.

Regarding the properties of the organic EL element including the hole injection layer 4 in FIG. 2B which is another embodiment of the present disclosure, compared to the organic EL element of Comparative Example 8 including a hole injection layer 4 of TcTa doped with F6TCNN, the organic EL element of Example 5 in which HAT-CN was inserted between the same hole injection layer 4 and the anode 3 had superior performance in both drive voltage and life. Moreover, compared to the organic EL element of Comparative Example 9 including a hole injection layer 4 of TcTa doped with TANP, the organic EL element of Example 7 in which HAT-CN was inserted between the same hole injection layer 4 and the anode 3 had superior performance in both drive voltage and life.

Thus, in the case of using a hole injection layer 4 in which a donor material is doped with an organic acceptor material, too, such stacking that provides an organic acceptor material low in electron affinity on the anode 3 and provides a layer containing a material high in electron affinity on the organic acceptor material low in electron affinity is effective in reducing the drive voltage and extending the life. In this case, forming, on the anode 3, a system in which an organic acceptor material low in electron affinity (HAT-CN) dopes another organic material is also one embodiment of the present disclosure.

### <Study of organic acceptor material relatively low in electron affinity used in first layer>

For the organic acceptor material relatively low in electron affinity used in the first layer, various materials (BCF3Ph-F8-Ant, BSBF, FP-ly-POA) were studied. The structures of BCF3Ph-F8-Ant (1,2,3,4,5,6,7,8-octafluoro-9,10-bis[4-(trifluoromethyl)phenyl]anthracene), BSBF (2-(9,9'-spirobifluorene-2-yl)-9,9'-spirobifluorene), and FP-ly-POA (4-fluorobenzylphosphonic acid) are as follows.

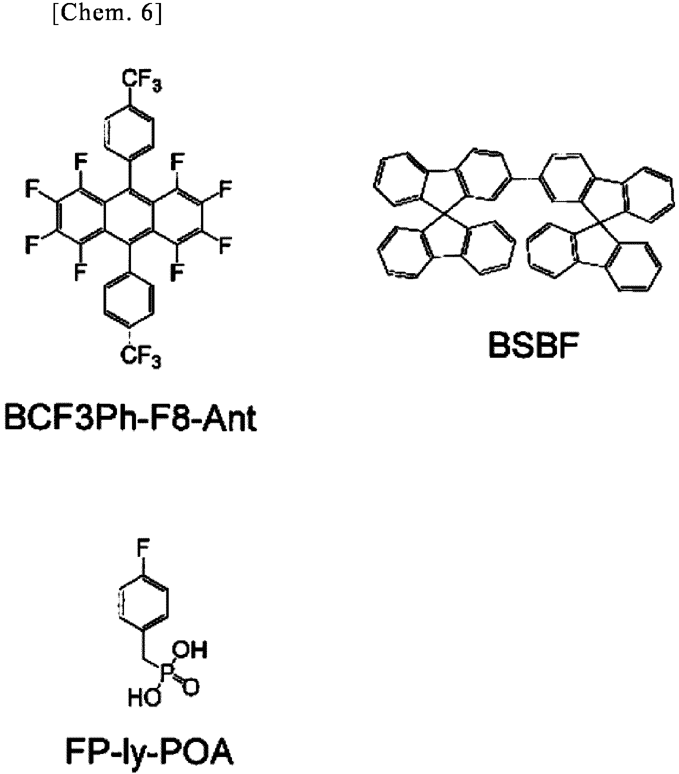

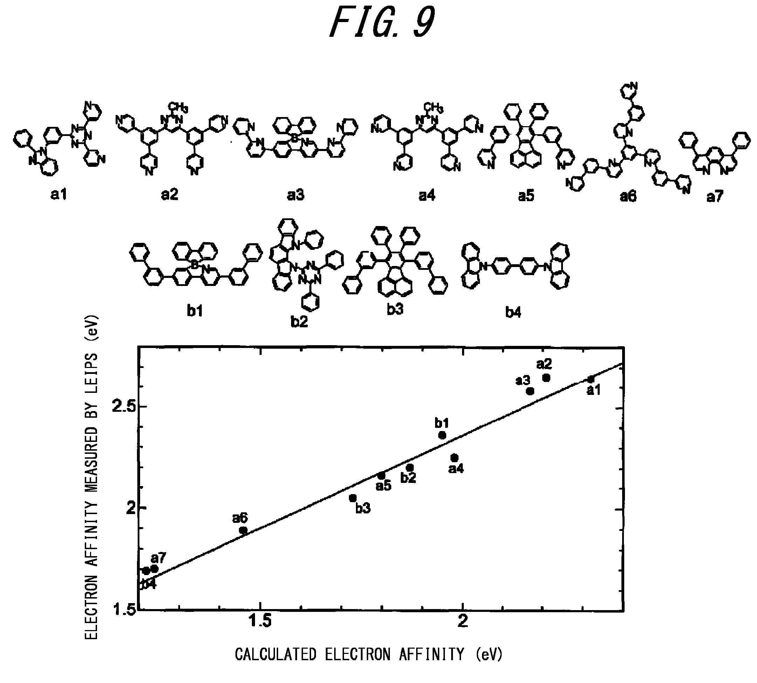

FIG. 9 illustrates the correlation between the measured and calculated electron affinity values for a plurality of organic materials (a1 to a7, b1 to b4). From the data illustrated in FIG. 9, the following formula can be obtained:
Measured electron affinity value = 0.92 × calculated electron affinity value + 0.52.

Based on this formula, the electron affinity was estimated from the calculated electron affinity value for BCF3Ph-F8-Ant, BSBF, and FP-ly-POA.

The electron affinity of each material is shown in Table 3.

**[Table 3]**

| | Calculated value of electron affinity (eV) | Electron affinity estimated from calculated value (eV) |
|---|---|---|
| BCF3Ph-F8-Ant | 2.52 | 2.83 |
| BSBF | 1.24 | 1.66 |
| FP-ly-POA | 0.35 | 0.84 |

### <Examples 9 to 11>

The organic EL elements of Examples 9 to 11 were produced using BCF3Ph-F8-Ant and BSBF in the first layer, in the same manner as in Examples 1 to 8.

For 4-fluorobenzylphosphonic acid (FP-ly-POA) which is a material forming a self-assembled monolayer, a 0.012 mass% ethanol solution was prepared, discharged onto a substrate, spin-coated at 3500 rpm for 45 seconds, and then heated at 105°C for 30 minutes in a nitrogen atmosphere. The substrate was then washed with ethanol, and redried at 80°C for 30 minutes in a nitrogen atmosphere to produce a self-assembled monolayer of FP-ly-POA. F6TCNNQ was vapor-deposited onto the monolayer to form a hole injection layer. Except for this, an organic EL element was produced in the same manner as in Examples 1 to 8.

For the organic EL elements of Examples 9 to 11 thus obtained, the relationship between the applied voltage and the luminance and the relationship between the applied voltage and the current density were examined in the same manner as in Examples 1 to 8. The obtained properties are summarized in Table 4. For comparison, the results of Comparative Example 3 are also shown in Table 4.

**[Table 4]**

| | Anode/Hole injection layer | Hole transport layer | Current density at 4V (mA/cm²) | Current density at 5V (mA/cm²) | Current density at 6V (mA/cm²) | Voltage at 10000 nits (V) | Current density at 10000 nits (mA/cm²) | Half luminance life from 10000 nits (hour) |
|---|---|---|---|---|---|---|---|---|
| Example 9 | ITO/BCF3Ph-F8-Ant 5 nm /F6TCNNQ 1 nm | TcTa 30 nm | 1.95 | 11.7 | 42.66 | 5.6 | 26.65 | - |
| Example 10 | ITO/BSBF 5 nm /F6TCNNQ 1 nm | TcTa 30 nm | 4.36 | 20.67 | 68.80 | 5.0 | 20.67 | 174 |
| Example 11 | ITO/FP-ly-POA /F6TCNNQ 1 nm | TcTa 30 nm | 4.68 | 22.63 | 65.77 | 4.8 | 17.51 | 286 |
| Comparative Example 3 | ITO/F6TCNNQ 1nm | TcTa 30 nm | 2.83 | 10.7 | 25.42 | 5.6 | 18 | 90 |

| | | | | | | | | |
|---|---|---|---|---|---|---|---|---|
| * The film thickness of ITO is all 100nm. | | | | | | | | |

As shown in Table 4, as a result of the material used for the first layer being inserted between ITO and F6TCNNQ, the organic EL elements of Examples 9 to 11 were able to be driven at a lower voltage than that of Comparative Example 3. In addition, almost all of the organic EL elements were found to have higher drive stability than that of Comparative Example 3.

BCF3Ph-F8-Ant is a fluorine-containing compound, BSBF is an aromatic hydrocarbon, and FP-ly-POA is a phosphonic acid and is a material forming a self-assembled monolayer. It was thus indicated that these materials are suitable for the first layer.

### INDUSTRIAL APPLICABILITY

The organic thin film according to the present disclosure can be used for organic EL elements, display devices, lighting devices, organic thin film solar cells, organic thin film transistors, etc.

### REFERENCE SIGNS LIST

- 1: organic EL element
- 2: substrate
- 3: anode
- 4: hole injection layer (organic thin film)
- 4-1: first layer
- 4-2: second layer
- 5: hole transport layer
- 6: light-emitting layer
- 7: electron transport layer
- 8: electron injection layer
- 9: cathode

## Claims

1. An organic thin film that is hole-injectable and contains two or more organic acceptor materials different in electron affinity, the organic thin film comprising:
a first layer containing an organic acceptor material relatively low in electron affinity; and
a second layer stacked on the first layer and containing an organic acceptor material relatively high in electron affinity,
wherein the organic acceptor material relatively low in electron affinity is lower in electron affinity than the organic acceptor material relatively high in electron affinity, and
the organic thin film is configured to be used with the first layer located on an anode side.

2. The organic thin film according to claim 1, wherein the organic acceptor material relatively low in electron affinity has an electron affinity of less than 4.5 eV, and
the organic acceptor material relatively high in electron affinity has an electron affinity of 4.5 eV or more.

3. The organic thin film according to claim 1, wherein the second layer is a film obtained by mixing the organic acceptor material relatively high in electron affinity with another organic material.

4. The organic thin film according to claim 1, wherein the organic acceptor materials are each a cyano-containing compound or a fluorine-containing compound.

5. The organic thin film according to claim 1, wherein the organic acceptor materials are each a compound containing a 2-methylenepropanedinitrile group.

6. The organic thin film according to claim 1, wherein the organic acceptor material relatively low in electron affinity is any of a fluorine-containing compound, an aromatic hydrocarbon, a phosphonic acid, and a material forming a self-assembled monolayer.

7. The organic thin film according to claim 1, wherein the organic acceptor material relatively low in electron affinity has an electron affinity of 0.35 eV or more and less than 4.5 eV.

8. An organic electroluminescent element comprising a cathode, a light-emitting layer, and an anode in the stated order, and comprising the organic thin film according to any one of claims 1 to 7 between the anode and the light-emitting layer,
wherein the first layer of the organic thin film is located on an anode side.

9. The organic electroluminescent element according to claim 8, wherein an average thickness of the organic thin film is 2 nm to 100 nm.

10. A display device comprising the organic electroluminescent element according to claim 8.

11. A lighting device comprising the organic electroluminescent element according to claim 8.

12. An organic thin film solar cell comprising the organic thin film according to any one of claims 1 to 7.

13. An organic thin film transistor comprising the organic thin film according to any one of claims 1 to 7.
